(19) Europäisches Patentamt

European Patent Office

Office européen des brevets

(11) **EP 0 913 668 B1**

(12) **EUROPÄISCHE PATENTSCHRIFT**

(45) Veröffentlichungstag und Bekanntmachung des Hinweises auf die Patenterteilung:
**10.04.2002 Patentblatt 2002/15**

(51) Int Cl.⁷: **G01D 5/244**, H03M 1/00

(21) Anmeldenummer: **98118145.6**

(22) Anmeldetag: **24.09.1998**

(54) **Verfahren zum Ermitteln des Phasenwinkels bei Positionsgebern mit sinusförmigen Ausgangssignalen**

Process for measuring the phase angle of position sensors with sinusoidal output signals

Procédé pour mesurer l'angle de phase dans capteurs de position avec des sorties sinusoidales

(84) Benannte Vertragsstaaten:
**DE FR GB IT**

(30) Priorität: **29.10.1997 DE 19747753**

(43) Veröffentlichungstag der Anmeldung:
**06.05.1999 Patentblatt 1999/18**

(73) Patentinhaber: **Ruf Electronics GmbH**
**85635 Höhenkirchen (DE)**

(72) Erfinder: **Schödlbauer, Dieter Dr.**
**81825 München (DE)**

(74) Vertreter: **von Bülow, Tam, Dr.**
**Patentanwalt**
**Mailänder Strasse 13**
**81545 München (DE)**

(56) Entgegenhaltungen:
**DE-A- 19 539 134**          **DE-A- 19 548 385**
**FR-A- 2 221 876**

EP 0 913 668 B1

**Beschreibung**

Die Erfindung bezieht sich auf ein Verfahren zum Ermitteln des Phasenwinkels bei Positionsgebern mit sinusförmigen Ausgangssignalen gemäß dem Oberbegriff des Patentanspruches 1.

Ein derartiges Verfahren ist aus der FR-A-2 221 876 bekannt. Dort ist ein Verfahren beschrieben, mit dem aus einem analogen sinusförmigen und einem analogen cosinusförmigen Signal ein digitales Signal erzeugt wird, das einen Winkel innerhalb eines zuvorbestimmten Quadranten repräsentiert. Das digitale Signal wird durch Division ermittelt, wobei der Dividend das sinusförmige Eingangssignal und der Divisor eine Summe bzw. eine Differenz des analogen sinusförmigen und des analogen cosinusförmigen Eingangssignals ist.

Ein weiteres Verfahren zum Ermitteln des Phasenwinkels eines Positionsgebers ist aus der DE 195 39 134 A1 bekannt.

Ein Sensor erzeugt ein sinusförmiges und cosinusförmiges elektrisches Ausgangssignal in Abhängigkeit von der relativen Drehstellung bzw. der relativen Lage des Positionsgebers. Beispielsweise können auf einem Gegenstand dessen Drehstellung oder Lage ermittelt werden soll, eine oder mehrere Spuren magnetisierter Inkremente aufgebracht sein, denen gegenüberliegend der Sensor angeordnet ist, der bei diesem Beispiel ein Magnetsensor ist. Aus diesen Sinus- und Cosinus-Signalen werden die Linearkombinationen

$$\text{Sinus } (\alpha) + \text{Cosinus } (\alpha)$$

und

$$\text{Sinus } (\alpha) - \text{Cosinus } (\alpha)$$

gebildet, wobei die dabei entstehenden Signale ebenfalls ein sinus- und ein cosinusförmiges Signal sind, die jedoch gegenüber den ursprünglichen Signalen um 45° phasenverschoben sind und deren Amplitude das $\sqrt{2}$-fache der Grundsignale ist. Durch Untersuchung des Vorzeichens der Sinus- und Cosinus-Signale wird der jeweilige Quadrant ermittelt. In Abhängigkeit von diesem Quadranten wird entweder die Arcustangensfunktion oder die Arcuscotangensfunktion gebildet, um den Lagewert ($\alpha$) zu ermitteln. Die Bildung der Tangens- und Cotangensfunktion erfolgt mittels sukzessiver Approximation zweier Analogspannungswerte. Die zentrale Rechenoperation ist dabei eine Multiplikation mit einem Analog/Digital-Wandler. Im mathematischen Sinne wird dabei eine vom Phasenwinkel $\alpha$ abhängige Zahl zwischen 0 und 1 auf den Wertevorrat des A/D-Wandlers abgebildet, mit deren Hilfe sich der gesuchte Phasenwinkel bzw. Lagewert $\alpha$ über eine Winkeltabelle bestimmen läßt.

Nachteilig an diesem sukzessiven Approximationsverfahren ist, daß die abgetasteten Analog-Signale während der gesamten Approximationsdauer zur Verfügung stehen müssen und in diesem Zeitraum konstant sein müssen. Dies bedingt einen hohen Aufwand für Stabilität der Analog-Bausteine, was insbesondere hinsichtlich Temperaturfehlern problematisch ist.

Ein weiteres Problem bei dem bekannten Verfahren liegt darin, daß während der Lebensdauer des Positionsgebers die Ausgangssignale des Sensors schwächer werden können, beispielsweise weil die Magnetisierung der abgetasteten Spuren schwächer wird, und damit die Amplitude der abgetasteten Signale sinkt. Durch die Quotientenbildung bei der Tangens- bzw. Cotangensfunktion kürzt sich ein Amplitudenfehler zwar theoretisch heraus. In der Praxis können aber die abgetasteten Signale so schwach werden, daß eine zuverlässige Bestimmung des Phasenwinkels bzw. des Lagewertes $\alpha$ nicht mehr möglich ist. Bei dem bekannten Verfahren kann ein solcher Fehler praktisch nicht erkannt werden, allenfalls dann, wenn überhaupt kein Meßwert mehr ausgegeben wird.

Die DE 195 48 385 A1 beschreibt ein Verfahren zum Ermitteln des Phasenwinkels bei Positionsgebern mit sinusförmigen Ausgangssignalen, bei dem die Ausgangssignale in Analog-Digital-Wandlern umgewandelt werden und alle Rechenoperationen rein digital ausgeführt werden.

Aufgabe der Erfindung ist es, das eingangs genannte Verfahren dahingehend weiter zu entwickeln, daß es bei verringertem Aufwand für elektronische Bauteile langzeitstabil hochgenaue Meßergebnisse liefert und zusätzlich eine Eigendiagnosemöglichkeit bietet, mit der die Qualität der gemessenen Werte beurteilt werden kann.

Diese Aufgabe wird durch die im Patentanspruch 1 angegebenen Merkmale gelöst. Vorteilhafte Ausgestaltungen und Weiterbildungen der Erfindung sind den abhängigen Patentansprüchen zu entnehmen.

Ein erster wichtiger Aspekt der Erfindung besteht darin, daß die analogen Ausgangssignale des Sensors Abtast- und Halteschaltkreisen zugeführt, dort taktweise zwischengespeichert und unmittelbar darauf durch je einen Analog- /Digitalwandler in digitale Werte umgewandelt werden. Diese digitalen Werte werden gespeichert und stehen für die weiteren Rechenoperationen als "konstante" Werte zur Verfügung, unabhängig davon, ob die Abtast- und Halteschaltkreise den gespeicherten analogen Wert stabil halten oder nicht. Die gesamte weitere Signalverarbeitung erfolgt ausschließlich digital.

Ein weiterer wichtiger Aspekt der Erfindung liegt darin, daß die Ermittlung der jeweiligen Quadranten, in denen sich die Sensorsignale befinden, in einem einschrittigen Code erfolgt, wodurch Instabilitäten an den Quadrantengrenzen vermieden werden.

Noch ein weiterer wichtiger Aspekt der Erfindung liegt darin, daß - im Gegensatz zum Stand der Technik - nicht mehr eine approximative Multiplikation durchgeführt, sondern eine effektive Ganzzahldivision, wodurch die Zykluszeiten kurz gehalten werden. Für diese Division sieht die Erfindung vor, daß der Divisor nur aus bestimmten Abschnitten der abgetasteten Spursignale ausgewählt wird, und zwar aus solchen, in denen das auf 1 normierte Spursignal zwischen ca. 0,7 und 1 liegt. Eine Division durch sehr kleine Zahlenwerte entfällt daher, was die Rechengenauigkeit erhöht. Zusätzlich läßt sich dadurch, daß der Absolutwert des Divisors bei einwandfrei arbeitender Meßanordnung nur innerhalb relativ enger Grenzen schwanken kann, eine Möglichkeit zur Eigendiagnose schaffen.

Dies erfolgt nach einer vorteilhaften Weiterbildung der Erfindung dadurch, daß der Absolutwert des Divisors mit einem fest vorgegebenen Schwellwert verglichen wird. Liegt der Absolutwert des Divisors unter diesem vorgegebenen Schwellwert, lassen sich daraus Rückschlüsse über die Qualität des Meßergebnisses ziehen und z.B. eine Vorhersage über einen zukünftigen Ausfall der Meßanordnung treffen.

Nach einer Weiterbildung der Erfindung wird, wenn das Spursignal in der Nähe einer Quadrantengrenze liegt und die Vorzeichen (Signum-Funktion) von Divisor und Dividend verschieden sind, was ein Anzeichen für fehlerhafte Spursignale ist, der ausgegebene Meßwert zwangsweise auf die Quadrantengrenze gesetzt, wodurch auch im kritischen Bereich der Quadrantengrenzen sehr genaue Meßergebnisse erhalten werden und keine Abfrage der Winkeltabelle erfolgt.

Prinzipiell arbeitet das erfindungsgemäße Verfahren so, daß der jeweilige Phasenwinkel oder Lagewert $\alpha$ als "Offset"-Wert gegenüber der vorangehenden Quadrantengrenze bestimmt wird. Der Wertebereich der Winkeltabelle ist dabei 0° bis 90°. Auch ist es möglich, den Phasenwinkel oder Lagewert $\alpha$ als Offset- bzw. Abstand zur nächstgelegen Quadrantengrenze zu bestimmen, wodurch der Wertebereich der Winkeltabelle auf 0° bis 45° halbiert werden kann.

Grundsätzlich ist noch darauf hinzuweisen, daß das Verfahren nach der Erfindung unabhängig von der primären Quelle der Spursignale ist und nicht auf magnetisch erzeugte Spursignale beschränkt ist.

Im folgenden wird die Erfindung anhand eines Ausführungsbeispiels im Zusammenhang mit der Zeichnung ausführlicher erläutert. Es zeigt:

Fig. 1    den Verlauf der Spursignale sowie weiterer rechnerisch ermittelter Signale in Abhängigkeit vom Phasenwinkel bzw. Lagewert $\alpha$;

Fig. 2    ein Diagramm ähnlich Fig. 1 mit dem Verlauf von Dividend und Divisor bei der Quotientenbildung mit Betragsschwellen zu Diagnosezwecken;

Fig. 3    ein Diagramm eines berechneten Lagewertes;

Fig. 4    eine Winkeltabelle für einen Quadranten; und

Fig. 5    ein Blockschaltbild mit Ablaufdiagramm zur Erläuterung des Verfahrens nach der Erfindung.

Verwendete Formeln und Abkürzungen:

| | |
|---|---|
| $\alpha$ : | Phasenwinkel $0 \leq \alpha \leq 2\pi$ |
| $U_i$ : | Signalspannungswerte mit Indices $0 \leq i \leq 3$ |
| A : | Amplitude der Spursignale |
| $\Phi(x)$ : | Sprungfunktion |
| | $\Phi(x)=0$ für $x \leq 0$ $\Phi(x)=1$ für $x > 0$ |
| $q_0, q_1$: | LSB und MSB des Quadranten |
| $q(\alpha)$ : | Nummer des Quadranten innerhalb einer Signalperiode, $0 \leq q \leq 3$ |
| adresse($\alpha$): | je nach Quadrant wechselnde Winkelfunktion mit der Bitbreite des A/D-Wandlers; dient zur Adressierung der Winkeltabelle über einen Quadranten, in binärer Darstellung mit Bits $z_n$, $0 \leq n \leq$ Bitbreite(A/D)-1 |
| datum($\alpha$): | Das zu einer Adresse der Winkeltabelle gehörige Datum |
| $D_n(\alpha)$: | Datenbit n des Datums, $0 \leq n \leq$ Bitbreite(A/D)-1 |
| $\Phi(\alpha)$ : | Berechneter Lagewert (Endergebnis); $0 \leq \Phi(\alpha) \leq 2^{\text{Bitbreite(A/D)+2}}-1$ |

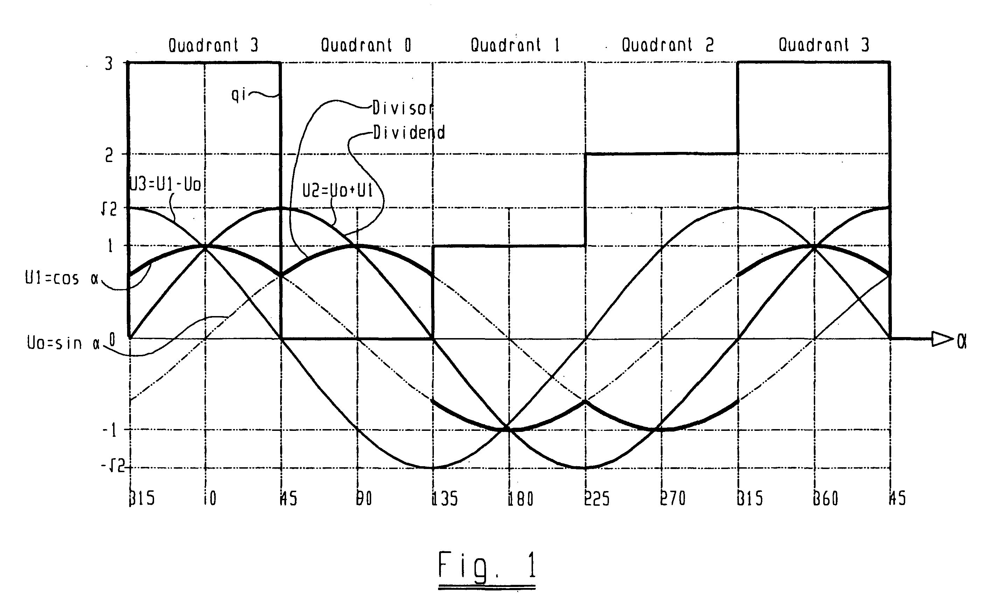

Fig. 1 zeigt den Verlauf der sinus- und cosinusförmigen Spursignale in Abhängigkeit vom Lagewert $\alpha$, also

$$U_0(\alpha) = A * \sin(\alpha) \qquad \text{Spursignal "Sinus"} \qquad\qquad (1)$$

$$U_1(\alpha) = A * \cos(\alpha) \qquad \text{Spursignal "Cosinus"} \qquad\qquad (2)$$

Diese Meßwerte können bedingt durch die Analog-/Digital-Wandlung zunächst einen (positiven) Offset von der Größe der halben Referenzspannung aufweisen. Nach einer entsprechenden Subtraktion entstehen die gewünschten, vorzeichenbehafteten Eingangswerte, wobei 1 Bit der Auflösung als Vorzeichenbit verlorengeht. Aus diesen Spursignalen werden die im Verlauf der Auswertung zusätzlich benötigen Linearkombinationen

$$U_2(\alpha) = U_1(\alpha) + U_0(\alpha) = A(\cos(\alpha) + \sin(\alpha)) \qquad\qquad (3)$$

$$U_3(\alpha) = U_1(\alpha) - U_0(\alpha) = A(\cos(\alpha) - \sin(\alpha)) \qquad\qquad (4)$$

durch Addition bzw. Subtraktion gebildet, deren Kurven ebenfalls sinusförmig mit einer Phasenverschiebung von +45° und einer $\sqrt{2}$-fachen Amplitude gegenüber den Spursignalen verlaufen.

Aus diesen Linearkombinationen werden die Sprungfunktionen

$$q_0(\alpha) = \Phi[U_2(\alpha)] \qquad\qquad (5)$$

$$q_1(\alpha) = \Phi[U_3(\alpha)] \qquad\qquad (6)$$

$$q(\alpha) = q_0(\alpha) + 2 * q_1(\alpha) \qquad\qquad (7)$$

gebildet, die mathematisch gesehen die Signumfunktion, also das Vorzeichen darstellen. Diese Sprungfunktionen werden jeweils durch Prüfen auf "0" realisiert mit:

$$U_2(\alpha) > 0 \Rightarrow q_0(\alpha) = 1$$

$$U_2(\alpha) \leq 0 \Rightarrow q_0(\alpha) = 0$$

$$U_3(\alpha) > 0 \Rightarrow q_1(\alpha) = 1$$

$$U_3(\alpha) \leq 0 \Rightarrow q_1(\alpha) = 0$$

Daraus ergibt sich ein einschrittiger 2-Bit-Code $q_1$, $q_2$ für die Abfolge der Quadranten. Dieser Code ist ähnlich dem Gray-Code einschrittig, d.h. bei Wechsel zum nächstfolgendem Quadrantenwert ändert sich immer nur 1 Bit. Allerdings liegt dieser Code q noch nicht in der gewünschten, monotonen Form vor. In dezimaler Darstellung stellt er sich als

1, 0, 2, 3 usw. anstelle von 0, 1, 2, 3 usw.

dar. Bei der Umrechnung in das endgültige "echte" Binärmuster $q_1$, $q_0$, gilt die folgende Funktionstabelle für $q_0$:

$$q_1$$

| $q_o$ | | 0 | 1 |
|---|---|---|---|
| | 0 | 1 | 0 |
| | 1 | 0 | 1 |

d.h. $q_0 = \overline{q_0}$ EXOR $q_1$

Für $q_1$ ist keine Umrechnung notwendig. Es gilt:

$$q_1$$

| $q_o$ | | 0 | 1 |
|---|---|---|---|
| | 0 | 0 | 1 |
| | 1 | 0 | 1 |

d.h. $q_1 = q_1$

Das Ergebnis dieser Umrechnung ist in Fig. 1 mit der stark durchgezogenen Linie $q_i$ dargestellt. Die anschließende Quotientenbildung für die Adressierung einer Winkeltabelle erfolgt mit dem

$$\text{dividend}(\alpha) = U_2(\alpha) \tag{8}$$

und je nach Quadrant mit unterschiedlichem Divisor, nämlich

$$\text{divisor}(\alpha) = U_0(\alpha) \text{ wenn } q_0(\alpha) = 0 \tag{9a}$$

$$\text{divisor}(\alpha) = U_1(\alpha) \text{ wenn } q_0(\alpha) = 1 \tag{9b}.$$

Der Zusammenhang zwischen den Quadranten 0 bis 3, dem Phasen- oder Lagewinkel $\alpha$ und dem Quotienten $f(\alpha)$ ergibt sich aus folgender Tabelle:

| Quadrant Nr. | Phasenwinkel $\alpha$ | Quotient $(\alpha)$ | Wertebereich von $f(\alpha)$ |
|---|---|---|---|
| 0 | $45° \leq \alpha < 135°$ | $\cot(\alpha) +1$ | $2 \geq f(\alpha) > 0$ |
| 1 | $135° \leq \alpha < 225°$ | $\tan(\alpha) +1$ | $0 \leq f(\alpha) < 2$ |
| 2 | $225° \leq \alpha < 315°$ | $\cot(\alpha) +1$ | $2 \geq f(\alpha) > 0$ |
| 3 | $315° \leq \alpha < 45°$ | $\tan(\alpha) +1$ | $0 \leq f(\alpha) < 2$ |

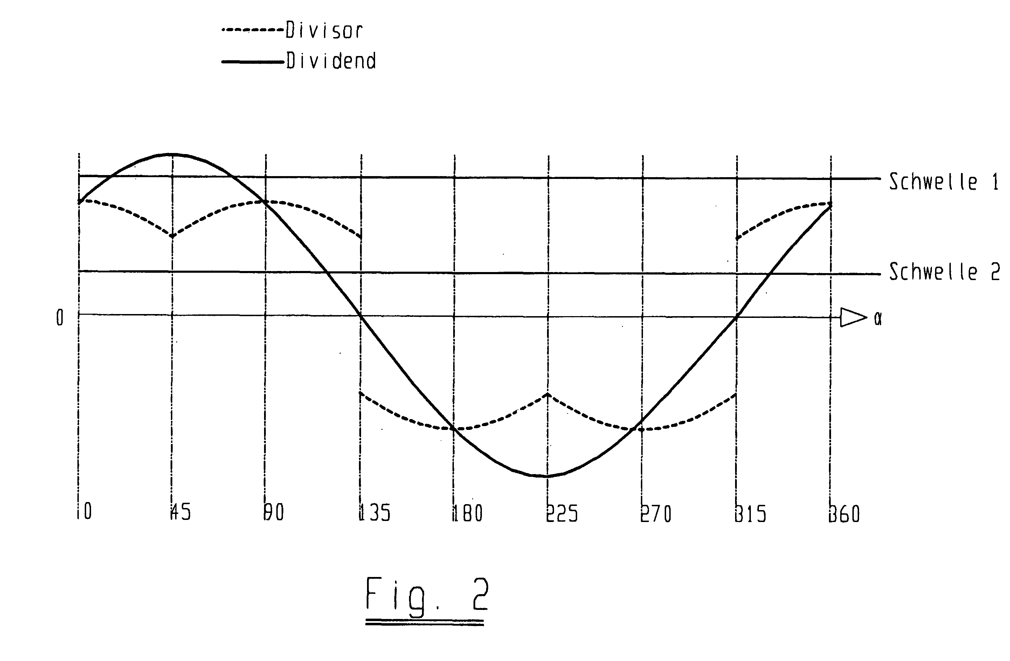

Dividend ist also immer die in Fig. 2 dargestellte Linearkombination U2 aus der Summe der beiden Spursignale. Divisor ist dagegen abwechselnd das sinus- oder cosinusförmige Signal U1 oder U2. Die entsprechenden Abschnitte dieser Spursignale, die den Divisor bilden, sind in Fig. 1 mit dickeren durchgezogenen Linien angegeben. Daraus ist zu erkennen, daß der Wertebereich der auf 1 normierten Spursignale betragsmäßig nur zwischen Sinus (45°) $\approx$ 0,71 und 1 liegen kann. Wie noch detaillierter aus Fig. 2 hervorgeht, ist es daher möglich, für den Betrag des Divisorsignals eine oder mehrere Schwellwerte für Diagnosezwecke zu definieren. Innerhalb eines Quadranten ändert sich der Betrag des Divisors maximal um $- (\sqrt{2}-1) / \sqrt{2} \approx - 29\%$ der Amplitude. Auf diese Weise können die Signalamplituden ohne aufwendige, d.h. zeitintensive Numerik überwacht werden. Der Betrag ergibt sich einfach durch Maskierung des Vorzeichenbits. Beispielsweise kann die in Fig. 2 eingezeichnete erste Schwelle 1 als obere Warngrenze dienen, während die Signalpegel unterhalb der Schwelle 2 als Systemausfall erkannt werden können. Durch weitere, nicht eingezeichnete Schwellwerte kann noch genauer erkannt werden, ob die Amplitude der Spursignale schon nahe einem Systemausfall ist.

Weiter ist aus Fig. 1 und 2 zu erkennen, daß Dividend und Divisor bei einwandfrei funktionierendem System stets dasselbe Vorzeichen haben müssen. Dies setzt natürlich voraus, daß die Phasenlage aller Signale exakt stimmt und auch keine unerwünschten Offset-Spannungen auftreten. An Quadrantengrenzen kann es aber in der Praxis vorkommen, daß das eine Signal schon sein Vorzeichen gewechselt hat, das andere aber noch nicht. In diesem Falle wird unabhängig vom Wert des Dividend und des Divisors festgelegt, daß der Lagewert $\alpha$ auf der Quadrantengrenze liegt. Für die Adressierung der Winkeltabelle gilt in diesem Falle

$$adresse(\alpha) =0 \;\; wenn \; sign(dividend) \neq sig(divisor) \tag{10a}$$

ansonsten gilt:

$$Adresse(\alpha)=2^{(Bitbreite(A/D)-1)} \cdot \frac{dividend(\alpha)}{divisor(\alpha)}$$

$$wenn \; sign(dividend) = sign(divisor) \tag{10b}$$

Die Berechnung der Adresse für die Winkeltabelle gemäß der vorgenannten Gleichung erfolgt durch sukzessives Bestimmen der Adreßbits $z_n$ mit Hilfe folgender Gleichung:

$$\sum_{n=0}^{Bitbr(A/D)-1} z_n(\alpha) \cdot (divisor(\alpha) \cdot 2^n) = dividend(\alpha) \cdot 2^{Bitbr(A/D)-1}$$

$$\tag{11}$$

wobei die Rechenoperation $* 2^i$ durch Verschieben um i Stellen nach links ausgeführt wird.

Damit ist dann eine Adresse für das Auslesen des Lagewertes Datum($\alpha$) aus einer Winkeltabelle bestimmt. Der Inhalt dieser Winkeltabelle ist, gerundet auf ganze Zahlen:

$$datum(\alpha)=2^{Bitbr(A/D)} \cdot [\frac{1}{2}+\frac{2}{\pi} \cdot \arctan(\frac{2}{2^{Bitbr(A/D)}} \cdot adresse(\alpha)-1)]$$

$$(mit \; Bitbr=Bitbreite) \tag{12}$$

Im ersten und dritten Quadranten ($q_0 = 0$) wird das ausgelesene Datum durch sein Einserkomplement ersetzt.

$$datum(\alpha) =\overline{datum \,(\alpha)} \qquad wenn \; q_0(\alpha) = 0 \tag{13a}$$

$$datum(\alpha)=datum(\alpha) \qquad wenn \; q_0(\alpha) = 1 \tag{13b}$$

Als Endergebnis erhält man:

$$\Phi(\alpha)=Datum(\alpha)+q_0(\alpha) \cdot 2^{Bitbreite(A/D)}+q_1(\alpha) \cdot 2^{Bitbreite(A/D)+1} \tag{14}$$

d.h. das Ergebnis ist von der Form

MSB $q_1$ , $q_0$, $D_{N-1}$ ..... $D_0$ LSB

| MSB | $q_1$ | $q_0$ | $D_{N-1}$ ..... $D_0$ | LSB |
|---|---|---|---|---|

$D_{N-1}$ bis $D_0$: Feinauflösung innerhalb des Quadranten $q_1$ $q_0$ mit N Bit

$q_1$ $q_0$ : Nummer des Quadranten, wobei MSB das "most significant bit", also das Bit mit der höchsten Wertigkeit und LSB das "lowest significant bit", also das Bit mit der geringsten Wertigkeit ist.

An dem ausgegebenen Format ist auch zu erkennen, daß die beiden höchstwertigen Bits $q_1$ und $q_0$ den jeweiligen Quadranten bestimmen und die aus der Winkeltabelle entnommenen Werte nur noch die Feinauflösung innerhalb des Quadranten bzw. den Versatz oder Offset gegenüber der vorangehenden Quadrantengrenze bestimmen.

Fig. 2 zeigt noch einmal den Verlauf des Divisors und des Dividenden sowie die beiden Schwellen 1 und 2, die die Eigendiagnose ermöglichen.

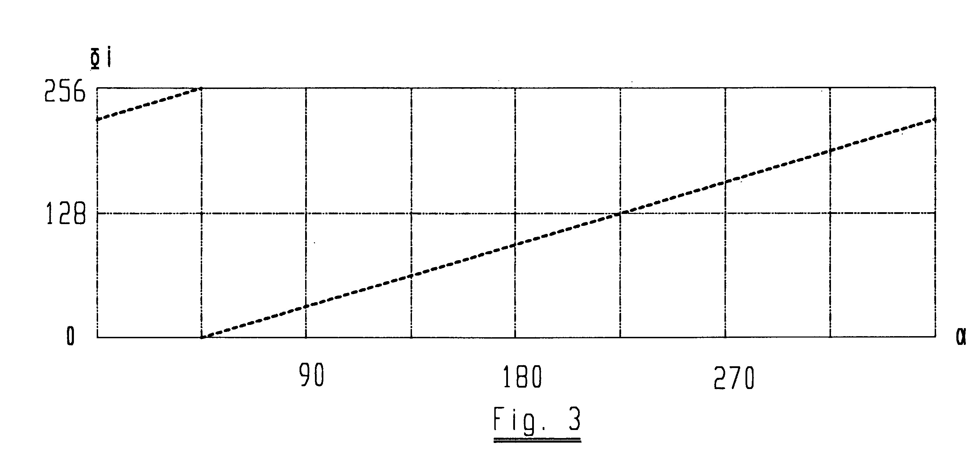

Fig. 3 zeigt den Verlauf des berechneten Lagewertes bei einer Auflösung von 8 Bit.

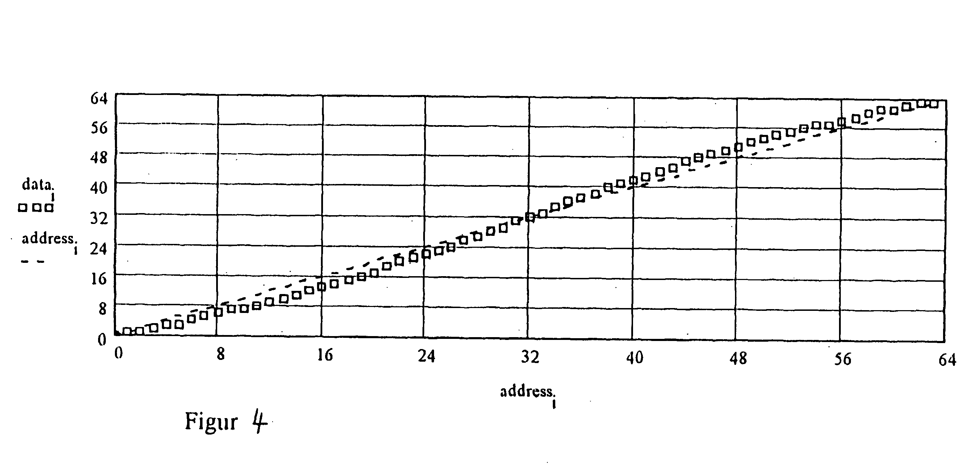

Fig. 4 zeigt ein Beispiel einer Winkeltabelle für einen Quadranten mit einer Auflösung von 6 Bit. Die für den berechneten Lagewert der Fig. 3 benötigten zwei weiteren Bits sind die Bits $q_1$ und $q_0$, die den jeweiligen Quadranten bestimmen. Die Winkeltabelle muß damit nur Werte für einen Quadranten enthalten. Die Verwendung einer Winkeltabelle hat den Vorteil, daß sie deutlich schneller ist als ein Rechnen der Arcustangens- oder Arcuscotangensfunktion. Im dargestellten Ausführungsbeispiel hat die Winkeltabelle die Breite eines vollen Quadranten, also 90°. Es wäre aber auch möglich, der Winkeltabelle nur eine Breite von 45° zu geben und dann den Wert nicht zur vorhergehenden Quadrantengrenze sondern zur nächst gelegenen Quadrantengrenze zu bestimmen.

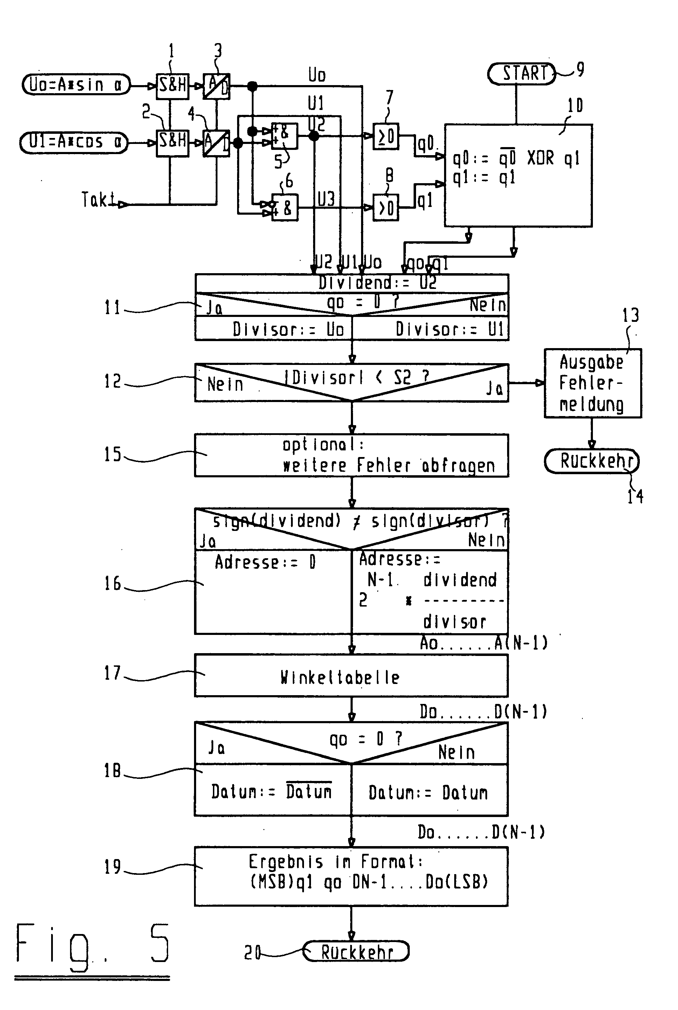

Fig. 5 zeigt ein Blockschaltbild mit Ablaufdiagramm zur Durchführung des Verfahrens nach der Erfindung. Die Eingangssignale $U_0$ und $U_1$ werden von nicht dargestellten Sensoren (z.B. Magnetfeldsensoren) erzeugt. Die beiden Signale $U_0$ und $U_1$ werden in je einer Abtast- und Halteschaltung 1 und 2 taktweise abgefragt und zwischengespeichert und unmittelbar darauf folgend in je einem Analog-/Digital-Wandler 3 bzw. 4 in ein digitales Signal umgewandelt und als digitales Signal gespeichert. Der A/D-Umwandlungsvorgang geht sehr schnell vor sich, so daß die Abtast- und Halteschaltkreise 1 und 2 keine Langzeitstabilität haben müssen. Das gesamte weitere Verfahren läuft dann rein digital ab. An die beiden A/D-Wandler 3 und 4 sind ein Addierer 5 und ein Subtrahierer 6 angeschlossen, die die Linearkombinationen $U_2 = U_0 + U_1$ bzw. $U_3 = U_1 - U_0$ bilden. In zwei Schwellwertschaltkreisen 7 und 8 wird überprüft, ob die Signale $U_2$ bzw. $U_3$ größer oder kleiner gleich 0 sind, womit gemäß den obigen Gleichungen (5) und (6) die Signale $q_0$ und $q_1$ für die Bestimmung des Quadranten gebildet werden.

Sodann läuft das eigentliche Verfahren mit einem Startsignal 9 an. In einem Block 10 erfolgt die Umrechnung des Signales $q_0$, um die gewünschte monotone Form des einschrittigen Codes für das Binärmuster $q_1$ $q_2$ zu erhalten, das auch in Fig. 1 dargestellt ist. In einem Block 11, dem die Signale $U_0$, $U_1$, $U_2$, $q_0$ und $q_1$ zugeführt werden, wird die Division vorbereitet. Hierzu wird überprüft, ob $q_0$ gleich 0 oder ungleich 0 ist. Ist $q_0$ gleich 0, so wird als Divisor das Spursignal $U_0$ ausgewählt, ist $q_0$ ungleich 0, so ist der Divisor $U_1$. In beiden Fällen ist der Dividend stets die Funktion $U_2$.

In einem Block 12 wird überprüft, ob der Divisor größer oder kleiner als die Schwelle 2 (Fig. 2) ist. Ist der Divisor kleiner als die Schwelle 2, so sind die Spursignale $U_0$ und/oder $U_1$ zu klein und in Block 13 erfolgt die Ausgabe einer Fehlermeldung und der weitere Rechenvorgang wird im Block 14 abgebrochen. Hierdurch kann mit einer einfachen Schwellwertabfrage eine Eigendiagnose durchgeführt werden. In einem optionalen Block 15 können weitere Fehler überprüft werden, beispielsweise ob andere Schwellwerte wie die Schwelle 1 über- oder unterschritten sind.

In einem weiteren Block 16 wird dann überprüft, ob die Vorzeichen von Dividend und Divisor gleich oder ungleich sind. Wie aus Fig. 2 zu erkennen ist, müssen bei exakten Signalen Divisor und Dividend gleiches Vorzeichen haben. An den Quadrantengrenzen zwischen Quadrant 0 und Quadrant 1 sowie zwischen Quadrant 2 und Quadrant 3 wechseln Divisor und Dividend ihr Vorzeichen. Dabei kann aber durch geringfügigste Phasen- oder Nullpunktsverschiebungen eine der beiden Funktionen das Vorzeichen schon gewechselt haben und die andere noch nicht, was je nach Präzision der Schwellwertabfrage 7 und 8 aber noch nicht als Quadrantenwechsel erkannt wurde. Daher ist vorgesehen, daß bei ungleichen Vorzeichen von Dividend und Divisor die Adresse für das Auslesen einer Winkeltabelle 17 auf 0 gesetzt wird, also auf den entsprechenden Quadrantenwechsel, ohne daß die Division durchgeführt wird. Sind die Vorzeichen von Dividend und Divisor dagegen gleich, so wird die Division im Block 16 als Ganzzahldivision durchgeführt gemäß der oben angegebenen Gleichung für den Wert Adresse ($\alpha$). Dieser Wert bzw. die Adresse 0 ist dann der Eingangswert für eine Winkeltabelle 17, in welcher in Abhängigkeit von der Adresse ($\alpha$) ein Winkelwert $D_0$... $D_{(N-1)}$ abgespeichert ist.

Da die Winkeltabelle nur Werte eines Quadranten enthält, wird in einem weiteren Block 18 in Abhängigkeit von dem Signal $q_0$ der ausgelesene Wert der Winkeltabelle ggf. noch transformiert. Ist $q_0$ gleich 0, so wird das 1er-Komplement des aus der Winkeltabelle ausgelesenen Datum genommen, ansonsten findet keine Veränderung statt.

In einem weiteren Block 19 wird dem ausgelesenen Datum noch der Wert des Quadranten mit den Bits $q_1$ und $q_0$ vorangestellt und das Ergebnis im angegebenen Format (MSB) $q_1$ $q_0$ $D_{(N-1)}$ ... $D_0$ (LSB) ausgegeben. Im Block 20 erfolgt dann die Rückkehr und ein neuer Zyklus kann beginnen.

Alle in den Bausteinen 5 bis 8 und den Blöcken 9 bis 20 dargestellten Rechenschritte bzw. logischen Operationen können selbstverständlich von einem programmierten Prozessor durchgeführt werden, dem lediglich die digitalisierten Spursignale aus den A/D-Wandlern 3 und 4 zugeführt werden.

**Patentansprüche**

1. Verfahren zum Ermitteln des Phasenwinkels bei Positionsgebern mit sinusförmigen Ausgangssignalen, wobei . ein Sensor in Abhängigkeit von der Lage oder Drehstellung $\alpha$ das sinusförmige Ausgangssignal
$U_0(\alpha) = A*\sin\alpha$ und ein cosinusförmiges Ausgangssignal
$U_1(\alpha) = A*\cos\alpha$ erzeugt, aus diesen Ausgangssignalen Linearkombinationen $U_2 = U_0 + U_1$ und
$U_3 = U_1 - U_0$ gebildet werden, bestimmt wird, in welchem Quadranten der Lagewert $\alpha$ ist und in Abhängigkeit von dem ermittelten Quadranten eine Division zur Bildung einer Tangensfunktion oder einer Cotangensfunktion durchgeführt wird und schließlich das Ergebnis der Division als Adresse zum Abfragen einer gespeicherten Winkeltabelle verwendet wird, deren Ausgabesignal mindestens die Feinauflösung des Lagewertes $\alpha$ darstellt, **dadurch gekennzeichnet,**
**daß** der Quadrant durch Untersuchung der Vorzeichen einiger der Signale $U_0$-$U_3$ bestimmt wird,
**daß** die analogen Ausgangssignale $U_0$, $U_1$ in Analog/Digital-Wandlern in digitale Signale umgewandelt werden,
**daß** alle weiteren Rechenoperationen rein digital durchgeführt werden,
**daß** die Vorzeichen der digitalisierten Ausgangssignale überprüft und daraus ein einschrittiger, binärer Code $q_1$ $q_0$ gebildet wird, der bestimmt, in welchem Quadranten sich der Lagewert $\alpha$ befindet,
**daß** zur Vorbereitung einer Ganzzahldivision, bei der der Dividend eine der Linearkombinationen ($U_2$, $U_3$) ist, als Divisor in Abhängigkeit vom ermittelten Quadranten entweder das sinus- oder das cosinusförmige Ausgangssignal ausgewählt wird, wobei der Betrag des Divisors dabei stets im Bereich oberhalb von $\sqrt{2}$ / 2 des Maximalwertes des jeweiligen Ausgangssignales liegt,
**daß** anschließend die Division durchgeführt wird, wobei das Ergebnis der Division die Adresse zum Auslesen der Winkeltabelle ist.

2. Verfahren nach Anspruch 1, **dadurch gekennzeichnet, daß** vor Durchführung der Division überprüft wird, ob der Betrag des Divisors einen vorgegebenen Schwellwert (S2) unterschreitet und in Abhängigkeit von dieser Überprüfung eine Fehlermeldung ausgegeben wird.

3. Verfahren nach Anspruch 1 oder 2, **dadurch gekennzeichnet,**
**daß** die gespeicherte Winkeltabelle nur Winkelwerte eines Quadranten enthält und daß zur Bildung des Lagewertes $\alpha$ dem aus der Winkeltabelle ausgelesenen digitalen Wert ($D_{n-1}$...$D_0$) der den jeweiligen Quadranten bestimmende Wert ($q_1$ $q_0$) vorangestellt wird.

4. Verfahren nach einem der Ansprüche 1 bis 3, **dadurch gekennzeichnet,**
**daß** die Adresse zum Auslesen der Winkeltabelle auf den Wert "0" gesetzt wird, wenn das Vorzeichen von Dividend und Divisor ungleich sind und daß die Division nur dann durchgeführt wird, wenn die Vorzeichen von Dividend und Divisor gleich sind.

5. Verfahren nach einem der Ansprüche 1 bis 4, **dadurch gekennzeichnet,**
**daß** zur Ermittlung des Quadranten die Linearkombinationen ($U_2$, $U_3$) daraufhin überprüft werden, ob ihr Wert größer oder kleiner gleich "0" ist.

6. Verfahren nach Anspruch 5, **dadurch gekennzeichnet, daß** die Linearkombination ($U_2$) aus der Summe der beiden Ausgangssignale ($U_0$, $U_1$) darauf überprüft wird, ob sie größer oder gleich "0" ist und die Linearkombination ($U_3$) aus der Differenz der beiden Ausgangssignale ($U_0$, $U_1$) darauf überprüft wird, ob sie größer "0" ist.

7. Verfahren nach Anspruch 6, **dadurch gekennzeichnet, daß** zur Bildung eines monotonen, einschrittigen Codes für den Quadranten der invertierte Wert der Überprüfung der Linearkombination ($U_2$) aus der Summe der beiden Ausgangssignale EXKLUSIVODER mit dem Wert ($q_1$) der Überprüfung der Linearkombination aus der Differenz der beiden Ausgangssignale ($U_1 - U_0$) verknüpft wird zur Bildung eines digitalen Signales ($q_0$), das das niederrangigere Bit des jeweiligen Quadranten darstellt und daß das Ergebnis der Überprüfung der Linearkombination der Differenz der beiden Ausgangssignale ($U_1$ - $U_0$) unverändert das höchstwertige Bit zur Bestimmung des jeweiligen Quadranten ist.

**Claims**

1. A method to ascertain the phase angle with respect to position sensors with sinusoidal output signals, wherein a sensor produces in dependence on the location or rotational position $\alpha$ the sinusoidal output signal $U_0(\alpha)$ = A*sin$\alpha$ and a cosinusoidal output signal $U_1(\alpha)$ = A*cos$\alpha$, linear combinations $U_2$ = $U_0$ + $U_1$ and $U_3$ = $U_1$ - $U_0$ are formed from these output signals, it is determined in which quadrant the location value $\alpha$ is, and in dependence on the quadrant ascertained a division is performed to form a tangent function or a cotangent function, and finally the result of the division is used as address to interrogate a stored angle table, the output signal of which represents at least the fine resolution of the location value $\alpha$, **characterised in that** the quadrant is determined by investigating the signs of some of the signals $U_0$-$U_3$,
   **in that** the analogue output signals $U_0$, $U_1$ are converted in analogue-to-digital converters into digital signals,
   **in that** all other arithmetical operations are performed purely digitally,
   **in that** the signs of the digitised output signals are checked and a stepping binary code $q_1$, $q_0$ is formed from them which determines in which quadrant the location value $\alpha$ is located,
   **in that**, in order to set up an integer division in which the dividend is one of the linear combinations ($U_2$, $U_3$), either the sinusoidal or the cosinusoidal output signal is selected as divisor in dependence on the quadrant ascertained, the value of the divisor always being in the region above $\sqrt{2}/2$ of the maximum value of the particular output signal,
   **in that** the division is then performed, the result of the division being the address for reading out the angle table.

2. A method according to claim 1, **characterised in that** before the division is performed, the check is made whether the value of the divisor is less than a predetermined threshold value (S2) and in dependence on this check an error message is issued.

3. A method according to claim 1 or 2, **characterised in that** the stored angle table only contains angle values of one quadrant and **in that** to form the location value $\alpha$ the digital value ($D_{n-1}$...$D_0$) read out of the angle table is preceded by the value ($q_1$, $q_0$) determining the particular quadrant.

4. A method according to one of claims 1 to 3, **characterised in that** the address for reading out the angle table is set at the value "0" if the sign of dividend and divisor are unlike, and **in that** the division can only be performed if the signs of dividend and divisor are like.

5. A method according to one of claims 1 to 4, **characterised in that**, to ascertain the quadrant, the linear combinations ($U_2$, $U_3$) are checked for whether their value is greater or smaller than "0".

6. A method according to claim 5, **characterised in that** the linear combination ($U_2$) of the sum of the two output signals ($U_0$, $U_1$) is checked for whether it is greater than or equal to "0" and the linear combination ($U_3$) of the difference of the two output signals ($U_0$, $U_1$) is checked for whether it is greater than "0".

7. A method according to claim 6, **characterised in that**, to form a repetitive, stepping code for the quadrant, the inverted value of the check of the linear combination ($U_2$) of the sum of the two output signals is combined EXCLUSIVE OR with the value ($q_1$) of the check of the linear combination of the difference of the two output signals ($U_1$ - $U_0$) to form a digital signal ($q_0$) which represents the lower-order bit of the particular quadrant, and **in that** the result of checking the linear combination of the difference of the two output signals ($U_1$ - $U_0$) unchanged is the most significant bit in order to determine the particular quadrant.

**Revendications**

1. Procédé pour mesurer l'angle de phase dans des capteurs de position avec des sorties sinosoïdales, dans lequel un capteur génère en fonction de la position ou de la position de rotation $\alpha$ le signal de sortie sinusoïdal $U_0(\alpha)$ = A*sin$\alpha$ et un signal de sortie cosinusoïdal $U_1(\alpha)$ = A*cos$\alpha$, des combinaisons linéaires $U_2$ = $U_0$ + $U_1$ et $U_3$ = $U_1$ - $U_0$ sont formées à partir de ces signaux de sortie, on détermine dans quel quadrant se trouve la valeur de position $\alpha$ et on effectue en fonction du quadrant déterminé une division pour la formation d'une fonction tangente ou d'une fonction cotangente et enfin on utilise le résultat de la division comme adresse pour interroger un tableau d'angles mémorisé, dont le signal à la sortie représente au moins la résolution précise de la valeur de position $\alpha$, **caractérisé en ce que**

le quadrant est déterminé en explorant les signes de quelques-uns des signaux $U_0$ à $U_3$,

les signaux de sortie analogiques $U_0$, $U_1$ sont convertis en signaux numériques dans des convertisseurs analogique-numérique,

toutes les autres opérations arithmétiques sont effectuées entièrement en numérique,

les signes des signaux de sortie numérisés sont vérifiés et à partir de cette vérification est formé un code cyclique binaire $q_1$ $q_0$ qui détermine dans quel quadrant se trouve la valeur de position $\alpha$,

pour la préparation d'une division à nombres entiers dans laquelle le dividende est l'une des combinaisons linéaires $(U_2, U_3)$, on sélectionne comme diviseur, en fonction du quadrant déterminé, soit le signal de sortie sinusoïdal soit le signal de sortie cosinusoïdal, le montant du diviseur se situant en l'occurrence toujours dans la plage au-dessus de $\sqrt{2}/2$ de la valeur maximale du signal de sortie en question,

la division est ensuite effectuée, le résultat de la division étant l'adresse pour extraire le tableau d'angles.

2. Procédé selon la revendication 1, **caractérisé en ce qu'**on vérifie, avant la réalisation de la division, si le montant du diviseur est inférieur à une valeur seuil prescrite (S2) et **en ce qu'**un message d'erreur est sorti en fonction de cette vérification.

3. Procédé selon la revendication 1 ou 2, **caractérisé en ce que** le tableau d'angles mémorisé ne contient que des valeurs angulaires d'un quadrant et que pour la formation de la valeur de position $\alpha$, à la valeur numérique ($D_{n-1}$... $D_0$) extraite du tableau d'angles est associée la valeur ($q_1$, $q_0$) déterminant le quadrant en question.

4. Procédé selon l'une des revendications 1 à 3, **caractérisé en ce que** l'adresse pour extraire le tableau d'angles est mise sur la valeur "0" si les signes de dividende et diviseur diffèrent et **en ce que** la division n'est donc effectuée que si les signes de dividende et diviseur sont égaux.

5. Procédé selon l'une des revendications 1 à 4, **caractérisé en ce que** pour la détermination du quadrant, les combinaisons linéaires $(U_2, U_3)$ sont vérifiées pour savoir si leur valeur est supérieure ou bien inférieure ou égale à "0".

6. Procédé selon la revendication 5, **caractérisé en ce que** la combinaison linéaire $(U_2)$ obtenue à partir de la somme des deux signaux de sortie $(U_0, U_1)$ est comparée pour savoir si elle est supérieure ou égale à "0" et la combinaison linéaire $(U_3)$ obtenue à partir de la différence des deux signaux de sortie $(U_0, U_1)$ est comparée pour savoir si elle est supérieure à "0".

7. Procédé selon la revendication 6, **caractérisé en ce que** pour la formation d'un code monotone cyclique pour le quadrant, la valeur inversée de la comparaison de la combinaison linéaire $(U_2)$ obtenue à partir de la somme des deux signaux de sortie est combinée en OU EXCLUSIF avec le résultat $(q_1)$ de la comparaison de la combinaison linéaire obtenue à partir de la différence des deux signaux de sortie $(U_1 - U_0)$, pour la formation d'un signal numérique $(q_0)$ qui représente le bit de rang inférieur du quadrant en question, et **en ce que** le résultat de la comparaison de la combinaison linéaire de la différence des deux signaux de sortie $(U_1 - U_0)$ reste le bit le plus significatif pour la détermination du quadrant en question.

Quadrant 3    Quadrant 0    Quadrant 1    Quadrant 2    Quadrant 3

$qi$

Divisor
Dividend

$U3 = U1 - Uo$

$U2 = Uo + U1$

$U1 = cos\ \alpha$

$Uo = sin\ \alpha$

$\alpha$

315  0  45  90  135  180  225  270  315  360  45

Fig. 1

EP 0 913 668 B1

------- Divisor
——— Dividend

Schwelle 1

Schwelle 2

0

α

0   45   90   135   180   225   270   315   360

Fig. 2

EP 0 913 668 B1

12

Fig. 3

Figur 4

EP 0 913 668 B1

U₀=A*sin α → 1 S&H → 3 A D ● — Uo

U1=A*cos α → 2 S&H → 4 A 1 ● — U1 — U2

5 +8 — U2

6 +8 — U3

7 ≥0 → q0

8 >0 → q1

START 9

10
q0 := q̄0 XOR q1
q1 := q1

Takt

U2 U1 Uo   q0 q1

Dividend:= U2
11   Ja      q0 = 0 ?      Nein
Divisor:= Uo        Divisor:= U1

12   Nein      |Divisor| < S2 ?      Ja → 13 Ausgabe Fehler-meldung → Rückkehr 14

15   optional: weitere Fehler abfragen

sign(dividend) ≠ sign(divisor) ?
Ja                              Nein
Adresse:= 0        Adresse:=
16                    N-1    dividend
                   2   * ---------
                          divisor

Ao......A(N-1)

17   Winkeltabelle

Do......D(N-1)

qo = 0 ?
18   Ja                    Nein
Datum:= D̄a̅t̅u̅m̅        Datum:= Datum

Do......D(N-1)

19   Ergebnis im Format:
(MSB)q1 qo DN-1....Do(LSB)

20 → Rückkehr

# Fig. 5